(19)

**Europäisches Patentamt**
**European Patent Office**
**Office européen des brevets**

(11)  **EP 3 001 572 A1**

(12)  # EUROPEAN PATENT APPLICATION

(43) Date of publication:
**30.03.2016 Bulletin 2016/13**

(51) Int Cl.:
*H03M 13/27* *(2006.01)*

(21) Application number: **14186891.9**

(22) Date of filing: **29.09.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Panasonic Corporation**
**Kadoma-shi**
**Osaka 571-8501 (JP)**

(72) Inventor: **Klenner, Peter**
**63225 Langen (DE)**

(74) Representative: **Grünecker Patent- und**
**Rechtsanwälte**
**PartG mbB**
**Leopoldstraße 4**
**80802 München (DE)**

(54)  **Interleaving by concatenation of convolutional and block interleaving**

(57)  The present invention relates to a hybrid de-interleaving method for de-interleaving input data, the method comprising the steps of: convolutionally de-interleaving (730-750, 1130-1150) the input data resulting into first intermediate data; first block de-interleaving (720, 1120) the first intermediate data, resulting into an output data. The inventions further relates to a corresponding hybrid de-interleaver, hybrid interleaving method and hybrid interleaver.

## Fig. 7

700

EP 3 001 572 A1

**Description**

**TECHNICAL FIELD**

The present invention relates to the field of digital communications, and more specifically to time interleavers and de-interleavers for bit-interleaved coding and modulation systems with quasi-cyclic low-density parity-check codes, and QAM modulation, as well as to corresponding methods, transmitters, and receivers.

**BACKGROUND OF THE INVENTION**

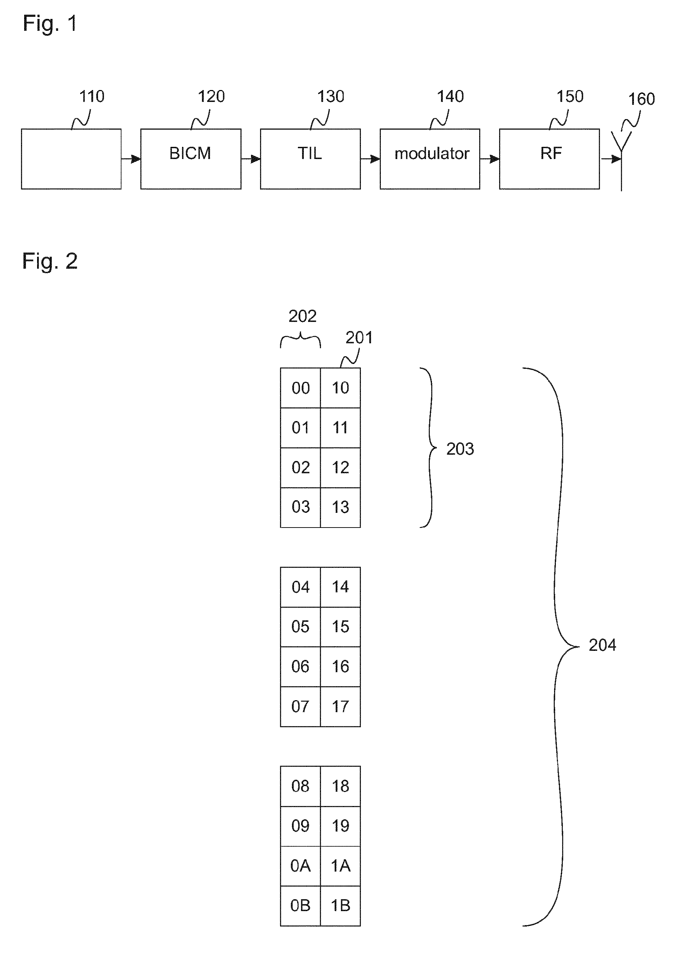

Figure 1 is a block diagram of a transmitter-side communication chain involving bit-interleaved coding and modulation BICM. The input processing unit 110 formats the input bitstreams into blocks of a predetermined length called baseband frames. The BICM encoder 120 converts the baseband frames into a plurality of complex-valued cells, which are further processed by a chain comprising at least a modulator 140, an RF frontend 150 to convert the digital signal to analog RF and power amplify the signal to be supplied to an antenna 160. The modulator 140 uses e.g. orthogonal frequency-division multiplexing OFDM modulation and typically includes time and frequency interleaving for increased diversity.

Between the BICM block 120 and the modulator 140 a time interleaver TIL 130 is placed.

The purpose of the time interleaver is to mitigate burst errors. In fact, in the presence of burst error, if the cells are interleaved in time, it is less likely that too many cells originally neighboring in the original data stream will be affected, thus rendering the recovery of the lost data easier, for instance when using a forward error correction coding approach

Several time interleaving techniques are known from state of the art communication systems like DVB-C2, DVB-T2, and DVB-NGH. Most systems employ multiple stages of interleaving. The rationale behind every interleaving method is to rearrange cells across several codewords.

For instance, a method used in DVB-T2 is row-column block interleaving. Conceptually, cells are written column-wise into a matrix and read out row-wise. Alternatively, convolutional interleaving is a method by which cells are written into FIFO-shift registers of increasing size. At half the memory size of block interleaving, it can realize the same time interleaving depth.

In the DVB-NGH specification ETSI EN 303 105, a hybrid interleaving scheme has been adopted, combining block interleaving with convolutional interleavers. Conceptually, the DVB-NGH-time interleaver convolutionally interleaves blocks of cells. One such block is called interleaving unit (IU). This combination was primarily chosen to allow for time-frequency-slicing (TFS), which is a promising technique to increase the multiplex capacity.

However, the DVB-NGH specification describes only the transmission sequence of the time interleaved cells, but lacks a description of the actual method how to generate such a sequence. This invention describes method and apparatus for implementing hybrid block and convolutional interleavers and de-interleaver.

**SUMMARY OF THE INVENTION**

It is an object of the present invention to provide an interleaver and corresponding de-interleaver, as well as the related interleaver and corresponding de-interleaver methods, which achieves the requirements described in the DVB-NGH specification ETSI EN 303 105 with an efficient use of memory and, more generally, computational resources.

It is a further object of this email to provide a simplified interleaver and corresponding de-interleaver, as well as the related interleaver and corresponding de-interleaver methods, which achieves the performances of the de/-interleaver described in the DVB-NGH specification ETSI EN 303 105 with a simplified structure.

One or more of the above mentioned objectives are achieved by the features as set forth in the independent claims. Preferred embodiments are the subject matter of dependent claims.

It is the particular approach of an embodiment of the present invention to implement a hybrid de/-interleaving scheme combining block interleaving with convolutional interleaving, conceptually convolutionally interleaving blocks of cells called interleaving unit (IU).

According to a first aspect of the present invention, the invention can relate to a hybrid de-interleaving method for de-interleaving input data, the method comprising the steps of: convolutionally de-interleaving (730-750, 1130-1150) the input data resulting into first intermediate data; first block de-interleaving (720, 1120) the first intermediate data, resulting into an output data.

Some aspects of the invention can further comprise the step of second block de-interleaving (710) the output data.

In some aspects of the invention the first (720) and/or second (710) block de-interleaving steps are carried out in accordance with DVB-T2, DVB-C2, or row-twisting block de-interleaving.

In some aspects of the invention the first and/or second block de-interleaving performs de-interleaving in accordance with the addressing scheme

$$(Eq1) \qquad a_{(i,j)} = (a_{(i-1,j)} + k_{(j)}) \ mod \ M + (a_{(i-1,j)} + k_{(j)}) \ div \ M$$

with

- $k_{(0)} = 1$
- $a_{(0,j)} = 0$
- $M = Nr \cdot Nc$

where $Nr$ is the number of rows and $Nc$ is the number of columns of the block de-interleaver and wherein $k_{(j)}$ is computed as

- $k_{(j)} = (k_{(j-1)} \cdot Nc) \ mod \ M + k_{(j-1)} \ div \ Nr$

In some aspects of the invention the first and/or second block de-interleaving performs de-interleaving in accordance with the addressing scheme

$$(Eq2) \qquad a_{(i,j)} = Nc * r_{(i,j)} + c_{(i,j)}$$

with

- $i = 0 \ ... \ Nr*Nc-1,$

- $c_{(i,j)} = mod(i, Nc)$

- $S_{(i,j)} = mod*(j*c_{(i,j)}, Nr)$

- $r_{(i,j)} = mod(s_{(i,j)} + floor(i/Nc), Nr)$

where $Nr$ is the number of rows and $Nc$ is the number of columns of the block de-interleaver.
In some aspects of the invention the first and/or second block de-interleaving performs de-interleaving in accordance with the addressing scheme

$$Shift = Nc/2+1 \ for \ mod(Nc,2)==0$$

$$Shift = (Nc+1)/2 \ for \ mod(Nc,2)==1$$

$$For \ j=0..N\_frames-1 \ \{$$

$$S = mod(S-Shift, \ Nc) \ with \ S=0 \ if \ j==0$$

$$For \ i=0..Nr*Nc-1 \ \{$$

$$R = mod(i, \ Nr)$$

$$T = mod(S*r, \ Nc)$$

$$C = mod(T+floor(i/Nr), \ Nc)$$

$$a_{(i,j)} = Nr*C+R$$

$$\}$$

$$\}$$

where *Nr* is the number of rows and *Nc* is the number of columns of the block de-interleaver.

In some aspects of the invention the step of convolutionally de-interleaving is logically equivalent to the operation of a convolutional de-interleaver comprising: a first switch (740, 1140) connecting the input of the convolutional de-interleaver to a plurality of branches, the number of branches being equal to the number of interleaving units in which the data to be de-interleaved is arranged; FIFO memories (730, 1130) connected to at least some of the branches; a second switch (750, 1150) connecting the branches to an output of the convolutional de-interleaver; wherein the first and/or second switch is configured to move to the next branch after a number of cells has passed though the switch, the number of cells being equal to the number of codewords per frame, and wherein the first and/or second switch is configured to move from one of the plurality of branches to the next one until the last branch of the plurality of branches is reached, and then to move from the last branch to the first one

A further aspect of the invention can relate to a hybrid de-interleaver (700), the de-interleaver being adapted for performing the steps of a method according to any of the above aspects.

A further aspect of the invention can relate to a hybrid interleaving method for interleaving input data, the method comprising the steps of: first block interleaving (520, 1020) the input data, resulting into first intermediate data; convolutionally interleaving (530-550, 1030-1050) the first intermediate data resulting into output data.

Some aspects of the invention can further comprise the step of second block interleaving (510) the input data before the first block interleaving step.

In some aspects of the invention the first (520) and/or second (510) block interleaving steps are carried out in accordance with DVB-T2, DVB-C2, or row-twisting block interleaving.

In some aspects of the invention the first and/or the second block interleaving performs interleaving in accordance with the addressing scheme

$$(Eq1) \qquad a_{(i,j)} = (a_{(i-1,j)}+k_{(j)}) \bmod M + (a_{(i-1,j)}+k_{(j)}) \ div \ M$$

with

- $k_{(0)} = 1$
- $a_{(0,j)} = 0$
- $M = Nr \cdot Nc$

where *Nr* is the number of rows and *Nc* is the number of columns of the block interleaver and wherein $k_{(j)}$ is computed as

- $k_{(j)} = (k_{(j-1)} \cdot Nr) \bmod M + k_{(j-1)} \ div \ Nc$

In some aspects of the invention the first and/or the second block interleaving performs interleaving in accordance with the addressing scheme

$$(Eq2) \qquad a_{(i,j)} = Nc * r_{(i,j)}+c_{(i,j)}$$

with

- $i = 0 \ ... \ Nr*Nc-1$,
- $c_{(i,j)} = \bmod(i, Nc)$
- $s_{(i,j)} = \bmod(j*c_{(i,j)}, Nr)$
- $r_{(i,j)} = \bmod(floor(i/Nc) - s_{(i,j)}, Nr)$

where *Nr* is the number of rows and *Nc* is the number of columns of the block interleaver.

In some aspects of the invention the first and/or the second block interleaving performs interleaving in accordance with the addressing scheme

$$Shift = Nc/2+1 \ for \ mod(Nc,2)==0$$
$$Shift = (Nc+1)/2 \ for \ mod(Nc,2)==1$$
$$For \ j=0..N\_frames-1 \ \{$$
$$S = mod(S-Shift, \ Nc) \ with \ S=0 \ if \ j==0$$
$$For \ i=0..Nr*Nc-1 \ \{$$
$$R = mod(i, \ Nr)$$
$$T = mod(S*r, \ Nc)$$
$$C = mod(floor(i/Nr)-T, \ Nc)$$
$$a_{(i,j)}=Nr*C+R$$
$$\}$$
$$\}$$

where $Nr$ is the number of rows and $Nc$ is the number of columns of the block interleaver.

In some aspects of the invention, the step of convolutionally interleaving is logically equivalent to the operation of a convolutional interleaver comprising: a first switch (540, 1040) connecting the input of the convolutional interleaver to a plurality of branches, the number of branches being equal to the number of interleaving units in which the data to be interleaved is arranged; FIFO memories (530, 1030) connected to at least some of the branches; a second switch (550, 1050) connecting the branches to an output of the convolutional interleaver; wherein the first and/or second switch is configured to move to the next branch after a number of cells has passed though the switch, the number of cells being equal to the number of codewords per frame, and wherein the first and/or second switch is configured to move from one of the plurality of branches to the next one until the last branch of the plurality of branches is reached, and then to move from the last branch to the first one.

A further aspect of the invention can relate to a hybrid interleaver (500), the interleaver being adapted for performing the steps of a method according to any of the above aspects.

The above and other objects and features of the present invention will become more apparent from the following description and preferred embodiments given in conjunction with the accompanying drawings, in which:

Figure 1 schematically illustrates a transmitter-side communication chain involving bit interleaved coding and modulation;

Figure 2 schematically illustrates a logical representation of data inputted to a time interleaver;

Figures 3A-3C schematically illustrate a logic operation of a time interleaver according to DVB-NGH specifications;

Figures 4A-4C schematically illustrate a logic operation of a time de-interleaver according to DVB-NGH specifications;

Figure 5 schematically illustrates one implementation of a hybrid interleaver in accordance with an embodiment of the present invention;

Figures 6A-6G schematically illustrate the operation of the interleaver of Figure 5;

Figure 7 schematically illustrates one implementation of a hybrid de-interleaver in accordance with an embodiment of the present invention;

Figure 8 schematically illustrates one implementation of a block interleaver in accordance with an embodiment of the present invention;

Figure 9 schematically illustrates simulation results;

Figure 10 schematically illustrates one implementation of a hybrid interleaver in accordance with an embodiment of the present invention;

Figure 11 schematically illustrates one implementation of a hybrid de-interleaver in accordance with an embodiment of the present invention.

## DETAILED DESCRIPTION

Figure 2 schematically illustrates a logical representation of data inputted to the time interleaver 130. In particular, in Figure 2, a single frame 204 is illustrated. The frame 204 comprises $N_{FEC\_TI}$ codewords 202, here equal to 2, each codeword comprising a plurality of cells 201. In this case, the number of cells in a codeword is $N_{cells}$, here equal to 12. Thus, each frame 204 comprises, in the example of Figure 2, a plurality of 24 cells. Furthermore, each frame 204 is logically divided in a plurality of $N_{IU}$ interleaving units 203, here equal to 3. This data structure will be used for clarifying how the interleaver 130 operates, it will be clear however that the present invention is not limited thereto and that alternative numerical numbers can be implemented instead.

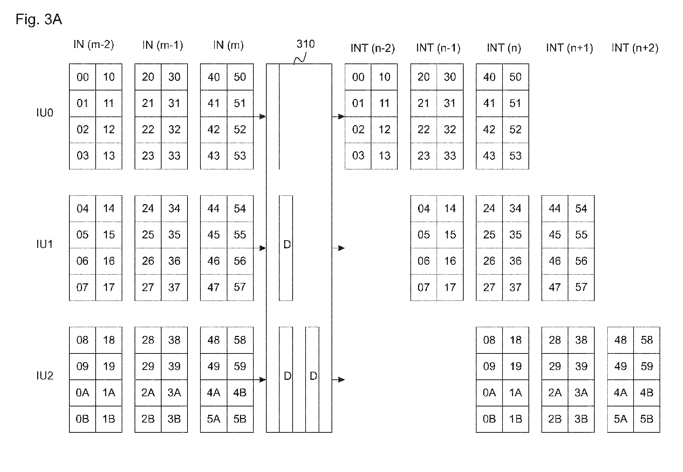

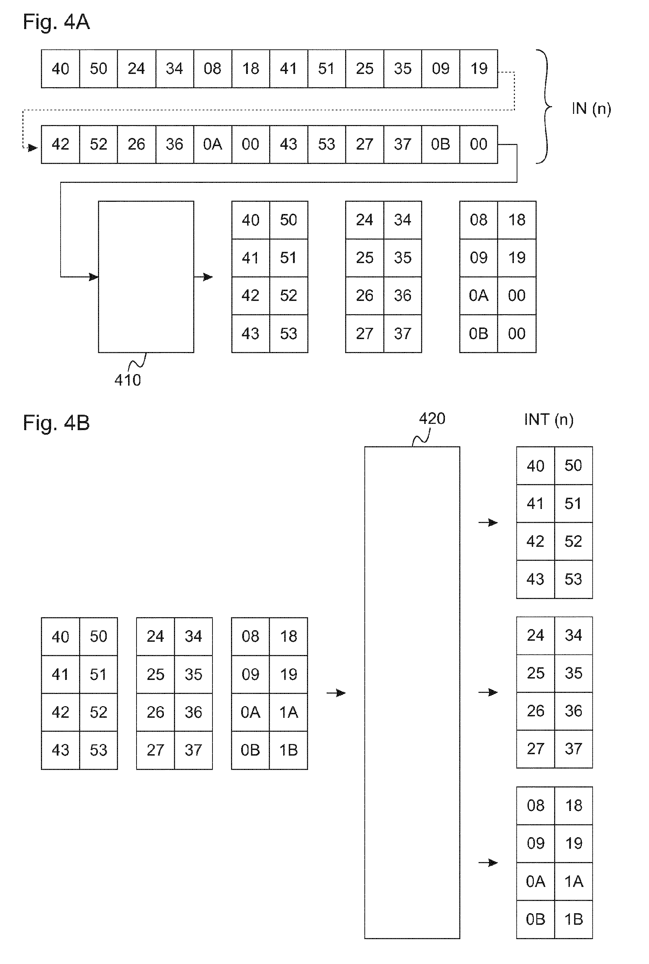

The DVB-NGH standard specifies the input and output of the time interleaver 130, and the corresponding de-interleaver, as respectively illustrated in Figures 3A-3C and 4A-4C.

In particular, Figure 3A schematically illustrates a first operation of a time interleaver 130 according to the DVB-NGH specification. The first operation of the interleaver 130 consists block interleaving codewords upon which interleaving units 203 are generated. More specifically, three exemplary successive input frames IN(m-2), IN(m-1) and IN(m) are represented as input. The interleaving units of the input frames are subjected to different time delays. In particular:

- the IU0 of each frame is not subjected to any delay, as illustrated by the lack of a delay line in the corresponding row, in delay element 310,

- the IU1 of each frame is subjected to a single unit delay, as illustrated by the presence of one delay line in the corresponding row, in delay element 310,

- the IU2 of each frame is subjected to a double unit delay, as illustrated by the presence of two delay lines in the corresponding row, in delay element 310.

The output of this first operation is illustrated by intermediate frames INT(n-2), INT(n-1), INT(n), INT(n+1), and INT(n+2). It will be clear that only intermediate frame INT(n) is complete, as the previous and successive frames should be completed by the time-delayed data coming from additional, not illustrated, input frames. It will be further noted that, the delay lines in delay element 310 operate on groups of cells, namely the interleaving units, and not on single cells as in the classic convolutional interleaving.

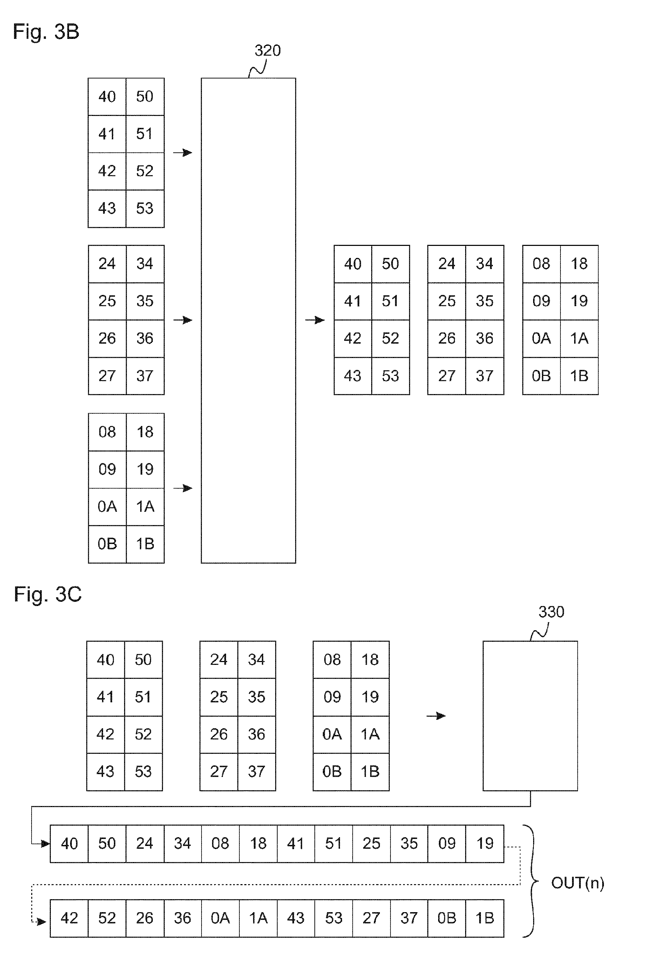

Figures 3B and 3C schematically illustrate a second operation of a time interleaver 130 according to DVB-NGH specifications. The second operation of the interleaver 130 consists in, for each intermediate frame, stacking the interleaving units 203 horizontally and then reading out the data row by row. More specifically, with reference to intermediate frame INT(n), the IU0, IU1 and IU2 are stacked horizontally, as illustrated by the stacking unit 320 in Figure 3B. The resulting data is then read out row by row, as illustrated by reading unit 330 in Figure 3C, resulting in the output string OUT.

It will be noted, in the output string OUT(n), how the cells are advantageously presenting a large spreading of codewords within the time interleaving depth. This can be achieved thanks to the stacking operation carried out by stacking unit 320.

When the stream of cells is received at the receiver, a de-interleaver carries out the inverse operation described for the interleaver. In summary, the cells will be divided in interleaving units, which will be stacked vertically to reconstruct the frames, further subjected to a time delay.

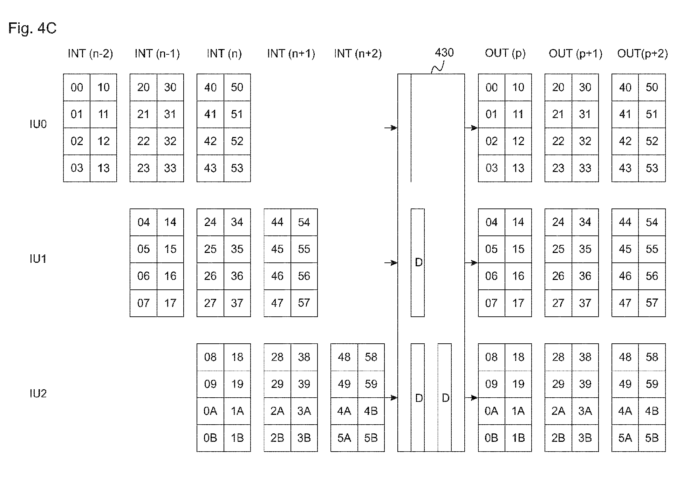

Figure 4A schematically illustrates a first operation of a time de-interleaver according to DVB-NGH specifications. The first operation of the de-interleaver consists in receiving the stream of data IN(n), corresponding to the OUT(n) data outputted from the interleaver 130 at the transmitter side. The cells are then inputted to a separating unit 410 which reconstructs the interleaving units. As visible in Figure 4B, the interleaving units are then inputted into a de-stacking unit 420 which reconstructs the frame. Finally, as illustrated in Figure 4C, a delay unit 430 applies, similarly to delay unit 310, a delay of 0 units to the interleaving unit IU0, a delay of 1 unit to the interleaving unit IU1 and a delay of 2 units to the interleaving unit IU2. In this manner, the frame OUT(p) corresponding to the originally sent frame IN(m-2) is recovered.

The above is however only a logical description of the operation of the interleaver and de-interleaver devices and method. Their implementation can be obtained in several manners, not necessarily employing the described units 310-330 and 410-430. In particular, the arrangement of data in the defined two-dimensional matrices and the moving of the data so as to place those matrices in different spatial position with respect to each other is only chosen since it simplifies the understanding of the de/-interleaving process. In preferred implementations, while the physical recording of the data may indeed be organized in a memory having a two dimensional array structure, the data are not necessarily physically re-arranged as described, but only logically rearranged, for instance by using an appropriate addressing scheme.

The invention provides a manner for implementing the de/-interleaving described above, with a reduced use of resources, preferably with a reduced use of memory on the de-interleaver. This is particularly advantageous, since the de-interleaver is more likely to be found in small, potentially portable, electronic devices, in which a reduction in memory advantageously results in a reduction in size and cost.

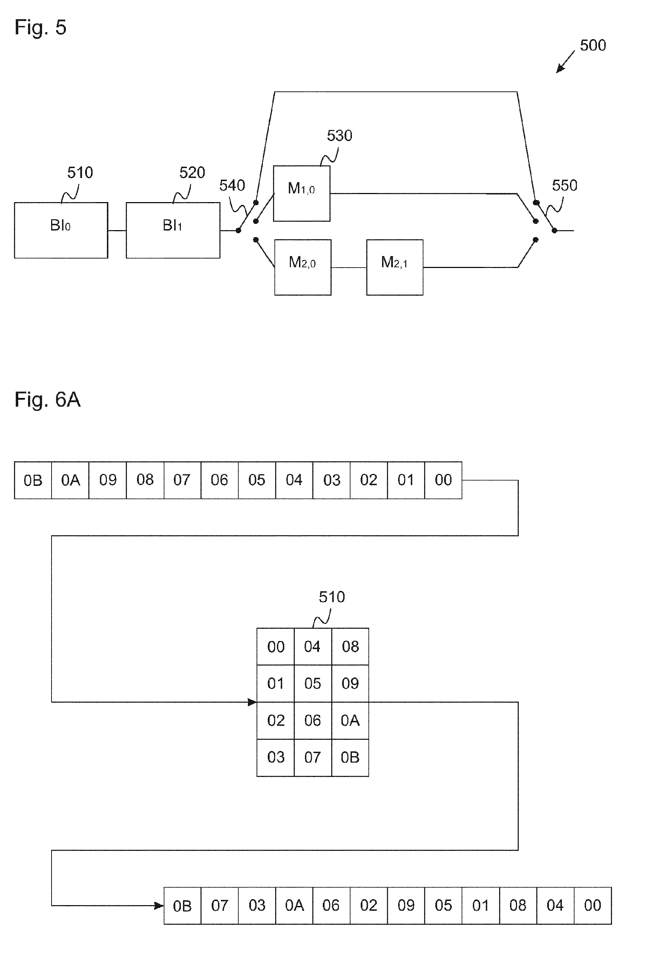

Figure 5 schematically illustrates one implementation of an interleaver 500 according to the present invention. In particular, the interleaver 500 comprises a row-column block interleaver $BI_0$ 510, connected to a block interleaver $BI_1$ 520. The output of block interleaver 520 is connected to a convolutional interleaver, logically represented by a plurality of memory units 530, switch 540 and switch 550. It will be clear to those skilled in the art that this is a logic representation only, and that the interleaver does not have to be physically realized as illustrated, i.e. comprising physical switches, but can be realized, for instance, by means of a memory and a processor.

The row-column block interleaver 510 comprises a number of rows equal to $N_{cells}/N_{IU}$, and a number of columns equal to $N_{IU}$, where $N_{IU}$ is the number of interleaving units per frame, for instance 3, and $N_{cells}$ is the number of cells per codeword, for instance 12. An exemplary implementation with such exemplary values is illustrated in Figure 6A. As can be seen in Figure 6A, the cells 00-0B are written into block interleaver 510 by rows, and read out in columns, resulting the sequence of cells, from the first to the last being outputted: 00, 04, 08, 01, 05, 09, 02, 06, 0A, 03, 07, 0B.

It will be clear to those skilled in the art that the implementation of such interleaver can be advantageously obtained with a linear block of memory operated by an addressing scheme as used for instance in the DVB-T2 implementation guidelines ETSI TS 102 831 "Digital Video Broadcasting (DVB); Implementation guidelines for a second generation digital terrestrial television broadcasting system (DVB-T2)", v1.2.1, August 2010, or also as described in patent application WO2010/061184, both of which are herewith enclosed in their entirety. In particular, such interleaver can be implemented by an addressing scheme which tracks a memory positions where the next cell can be read, and reuses these positions to write the currently incoming cells. More specifically, the address $a_{(i,j)}$ of the i-th element of the j-th TI-block is computed according to equation 1:

$$(Eq1) \quad a_{(i,j)} = (a_{(i-1,j)}+k_{(j)}) \ mod \ M + (a_{(i-1,j)}+k_{(j)}) \ div \ M$$

with

- $k_{(0)} = 1$

- $a_{(0,j)} = 0$

- $M = Nr \cdot Nc$

where *Nr* is the number of rows and *Nc* is the number of columns. At the transmitter-side interleaving, $k_{(j)}$ is computed as follows:

- $k_{(j)} = (k_{(j-1)} \cdot Nr) \ mod \ M + k_{(j-1)} \ div \ Nc$

The advantage of such approach is that a single buffer can be used for reading and writing cells, having and alternating between two buffers is not necessary. This allows using a single block of linear RAM for block interleaving and, by analogy, also for block de-interleaving. With that, the memory size of an actual block de-/interleaver can be the same as its conceptual size. For instance, in order to interleave or de-interleave a frame comprising 12 cells, a block of memory having memory space for 12 cells can be used.

The block interleaver 520 comprises a number of rows equal to $N_{cells}$, and a number of columns equal to $N_{FEC\_TI}$, where $N_{cells}$ is the number of cells per codeword, for instance 12, and $N_{FEC\_TI}$ is the number of codewords per frame, for instance 2.

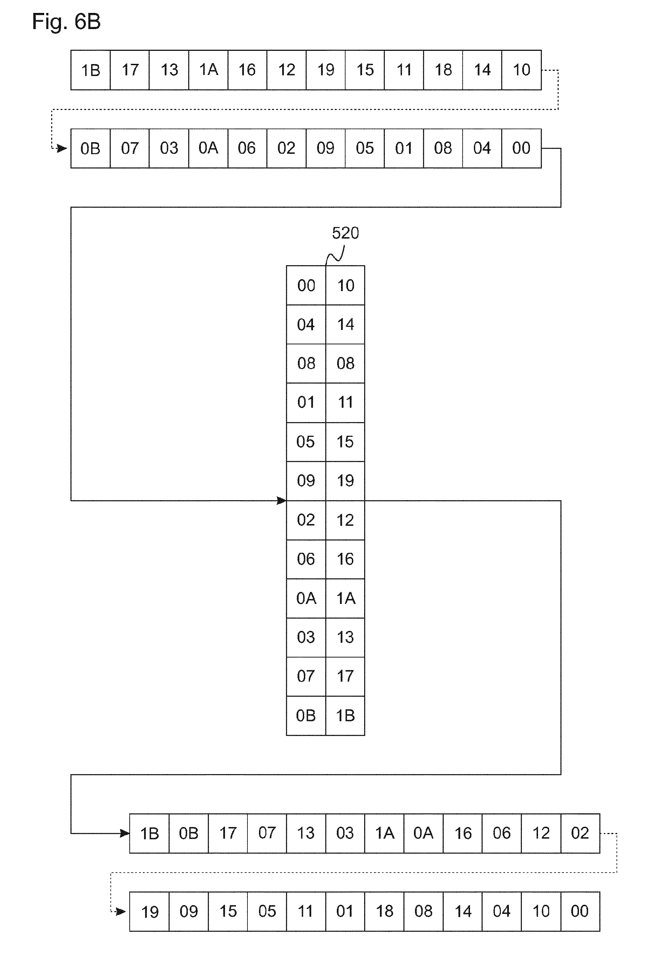

An exemplary implementation of block interleaver 520 with such exemplary values is illustrated in Figure 6B. As can be seen in Figure 6B, the cells 00-0B, in the order outputted by the row-column block interleaver 510 are written into block interleaver 520 by rows, and read out in columns. Additionally, the cells 10-1 B resulting from the subsequent frame are shown. The corresponding output from block interleaver 520 is the sequence of cells, from the first to the last being outputted: 00, 10, 04, 14, 08, 18, 01, 11, 05, 15, 09, 19, 02, 12, 06, 16, 0A, 1 A, 03, 13, 07, 17, 0B, 1 B. I n this case, the block interleaver 520 is operated as a row-column block interleaver, such as row-column block interleaver 520. Thus the same considerations made for row-column block interleaver 510 applies, in particular concerning the possible addressing implementation described by equation 1.

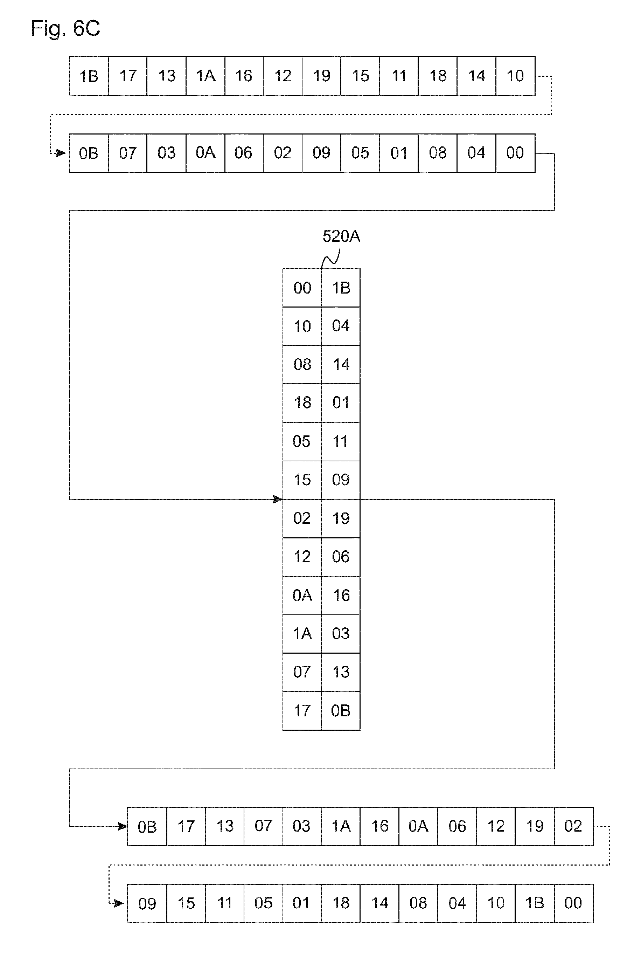

An alternative exemplary implementation with such exemplary values is illustrated in Figure 6C and indicated as block interleaver 520A. It will be clear that block interleaver 520A can be implemented, in the present invention, whenever reference is made to the block interleaver 520. The cells 00-0B, in the order outputted by the row-column block interleaver 510 are written into block interleaver 520A. However, instead of being inputted in a column direction, as in block interleaver 520, they are inputted diagonally. In a manner similar to block interleaver 520, the cells are then read out in rows. This results in the sequence of cells, from the first to the last being outputted, 00, 1 B, 10, ..., 13, 17, 0B, as illustrated in Figure 6C.

The implementation of such interleaver can be advantageously obtained with a linear block of memory operated by an addressing scheme as used for instance in the DVB-C2 specification ETSI EN 302 769, "Digital Video Broadcasting (DVB); Frame structure channel coding and modulation for a second generation digital transmission system for cable systems (DVB-C2)", v1.2.1, April 2011, which is herewith enclosed in its entirety. In particular, such interleaver can be implemented by an addressing scheme which tracks a memory positions where the next cell can be read, and reuses these positions to write the currently incoming cells. More specifically, the address $a_{(i,j)}$ of the i-th element of the j-th TI-block is computed according to equation 2:

$$(Eq2) \qquad a_{(i,j)} = Nc * r_{(i,j)} + c_{(i,j)}$$

with

-    i = 0 ... Nr*Nc-1,

-    $c_{(i,j)}$ = mod(i,Nc)

-    $s_{(i,j)}$ = mod(j*$c_{(i,j)}$, Nr)

-    $r_{(i,j)}$ = mod(floor(i/Nc) - $s_{(i,j)}$, Nr)

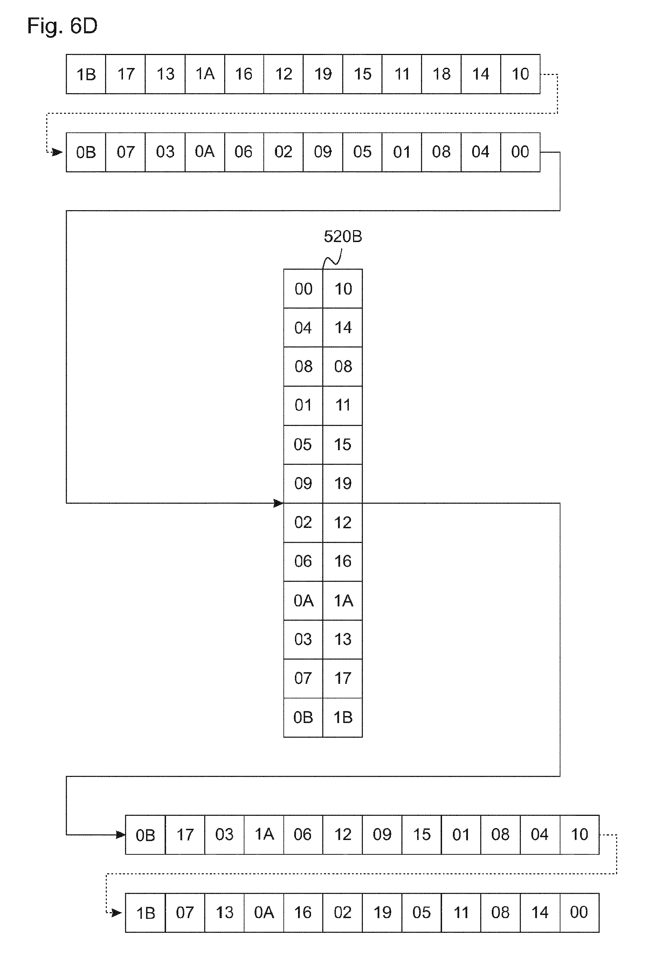

A further alternative exemplary implementation with such exemplary values is illustrated in Figure 6D and indicated as block interleaver 520B. It will be clear that block interleaver 520B can be implemented, in the present invention, whenever reference is made to the block interleaver 520. The cells 00-0B, in the order outputted by the row-column block interleaver 510 are written into block interleaver 520B by columns. However, before being read out, a row-twisting process is performed. This results in the sequence of cells, from the first to the last being outputted, 00, 14, 08, ..., 03, 17, 0B, as illustrated in Figure 6D.

The implementation of such interleaver can be advantageously obtained with a linear block of memory operated by an addressing scheme which tracks a memory positions where the next cell can be read, and reuses these positions to write the currently incoming cells. More specifically, the address $a_{(i,j)}$ of the i-th element of the j-th TI-block is computed according to the following implementation:

$$Shift = Nc/2+1 \ for \ mod(Nc,2)==0$$

$$Shift = (Nc+1)/2 \ for \ mod(Nc,2)==1$$

$$For \ j=0..N\_frames-1 \ \{$$

$$S = mod(S\text{-}Shift, \ Nc) \ with \ S=0 \ if \ j==0$$

$$For \ i=0..Nr*Nc-1 \ \{$$

$$R = mod(i, \ Nr)$$

$$T = mod(S*r, \ Nc)$$

$$C = mod(floor(i/Nr)\text{-}T, \ Nc)$$

$$a_{(i,j)}=Nr*C+R$$

$$\}$$

$$\}$$

Block interleavers 520A and 520B can be advantageous over block interleaver 520, as they have the benefit of either supplementing or replacing a cell interleaver, otherwise placed before block interleaver 510. In particular, in DVB-NGH, the cell interleaver may be required before block interleaver 510, in order to perform a pseudo random permutation of cells within a codeword. Thanks to interleavers 520A and 520B, the presence of such cell interleaver may be avoided.

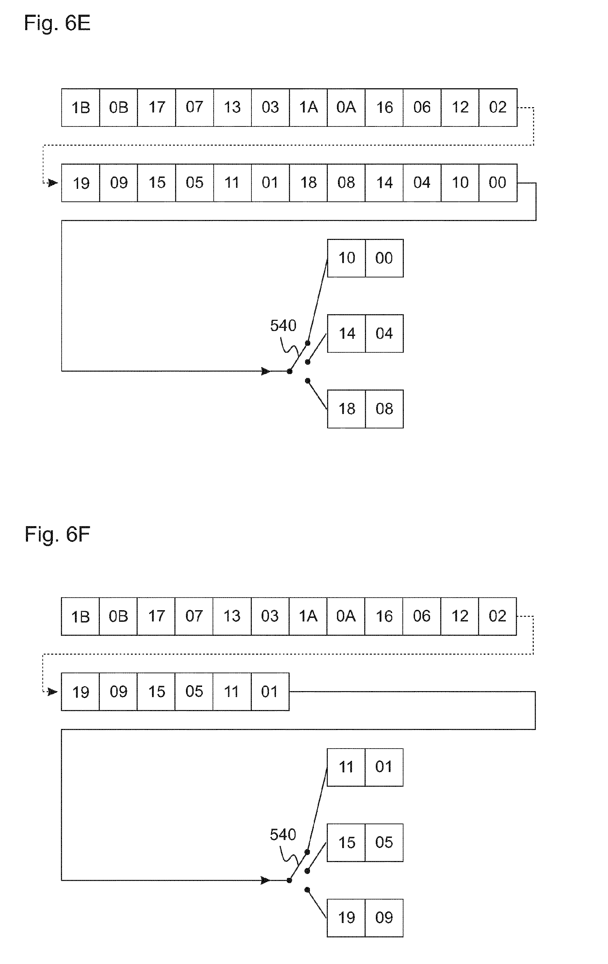

The switches 540 and 550 move by one position after $N_{FEC\_TI}$ cells have been passed. The number of positions to which the switch is connected, that is, the number of branches in the convolutional interleaver, is equal to $N_{IU}$. In an example consistent with the exemplary numerical values described above, the first three steps of switch 540 and the respective output cells are illustrated in Figure 6E and the subsequent three steps are illustrated in Figure 6F, using as input data the data from the output of block interleaver 520 as illustrated in Figure 6B.

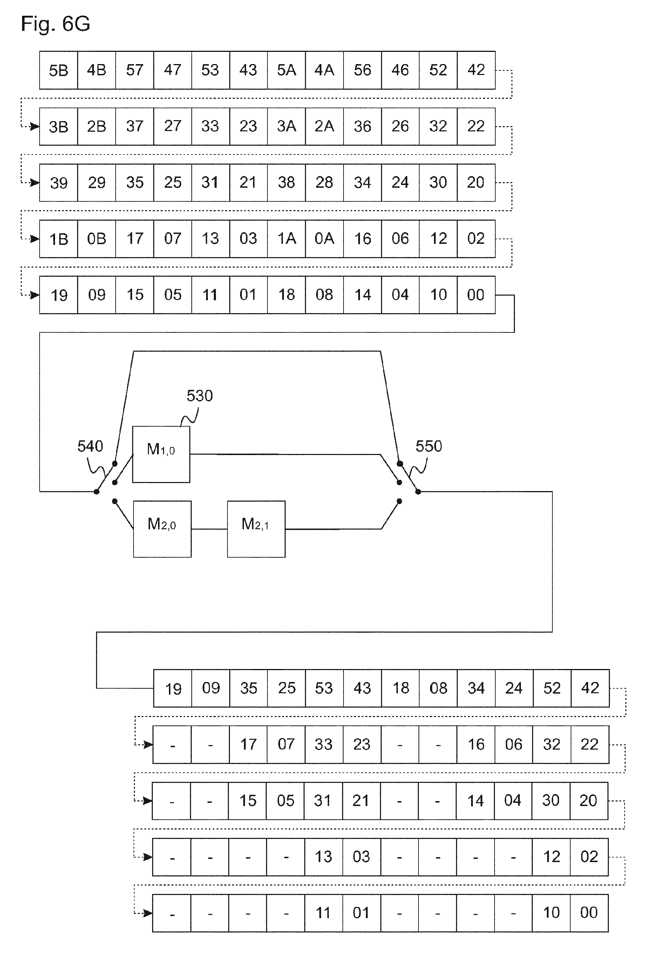

The cells outputted from switch 540 are then passed to the branch to which the switch is currently connected. The topmost branch does not contain any delay element, while the lower branches contain 1, 2, 3, 4, etc. delay elements in order, adding one more delay element for each lower branch. Each delay element $M_{x,y}$ works as a FIFO shift register and contains $N_{cells} / N_{IU*} N_{FEC\_TI}$ memory cells, which, by using the same exemplary numerical values described above results into 12 / 3 * 2 equal to 8 memory cells in the present exemplary embodiment. Figure 6G schematically illustrates the operation of the convolutional interleaver for the first four frames. The empty cells in the output are due to the progressive filling of the memory units 530. In particular, the three exemplary memory units of the present embodiment can hold a total of three times 8 cells, for a total of 24 cells, corresponding to the 245 empty cells in the output. Starting from cell 42, the data is continuously present.

It will be clear to those skilled in the art that ring buffers can be used in order to implement the delay lines, or memory units 530, which has the advantage of avoiding physically copying of memory units. In this manner, power can be advantageously saved, providing a significant advantage in mobile devices.

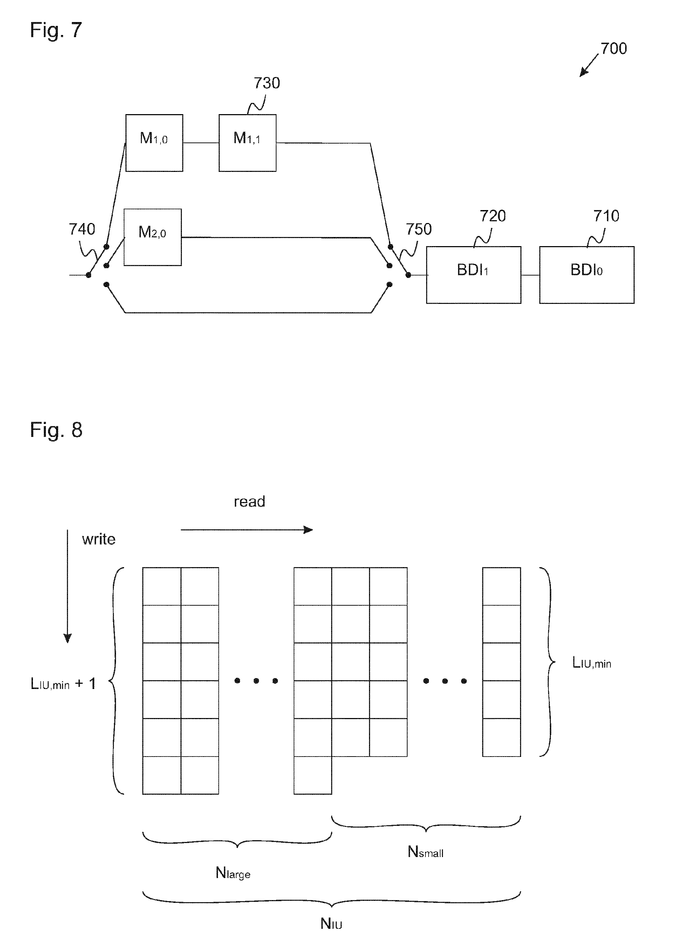

Figure 7 schematically illustrates one implementation of a de-interleaver 700 according to the present invention. In particular, the de-interleaver 700 comprises a convolutional de-interleaver schematically illustrated by a switch 740, memory units 730 and a switch 750. The output of the convolutional de-interleaver is connected to block de-interleaver $BDI_1$ 720, which is in turn connected to row-column block de-interleaver $BDI_0$ 710. It can thus be seen how the de-interleaver 700 is substantially symmetric with respect to the interleaver 500.

The convolutional de-interleaver operates in a manner substantially similar to the convolutional interleaver operation described with reference to Figures 6E-6G, in particular with respect to the number of cells in each memory element 730 as well as the speed of movement of the switches 740 and 750, and a detailed description thereof will thus be omitted.

The block de-interleaver 710 has $N_{cells}/N_{IU}$ rows and $N_{IU}$ columns.

A single memory implementation of the block de-interleaver 710 can be obtained, in symmetry with the block interleaver 510, by a memory using the addressing scheme described by equation 1:

$$(Eq1) \qquad a_{(i,j)} = (a_{(i-1,j)}+k_{(j)}) \; mod \; M + (a_{(i-1,j)}+k_{(j)}) \; div \; M$$

with

- $k_{(0)} = 1$
- $a_{(0,j)} = 0$
- $M = Nr \cdot Nc$

where $Nr$ is the number of rows and $Nc$ is the number of columns. At the receiver-side de-interleaving, $k_{(j)}$ is computed as follows:

- $k_{(j)} = (k_{(j-1)} \cdot Nc) \; mod \; M + k_{(j-1)} \; div \; Nr$

Block de-interleaver 720 has $N_{cells}$ rows and $N_{FEC\_TI}$ columns.

A single memory implementation of the block de-interleaver 720 can be obtained, in symmetry with the block interleaver 520, by a memory using the addressing scheme described by equation 1 for the receiver side de-interleaving addressing, as per block de-interleaver 710 above.

Alternatively, when using the block interleaver 520A, a corresponding block de-interleaver can be implemented by using the following addressing scheme:

$$(Eq2) \qquad a_{(i,j)} = Nc * r_{(i,j)} + c_{(i,j)}$$

with

- $i = 0 \; ... \; Nr*Nc-1$,

- $c_{(i,j)} = mod(i,Nc)$

- $s_{(i,j)} = mod(j*c_{(i,j)}, \; Nr)$

- $r_{(i,j)} = mod \; (s_{(i,j)}+floor(i/Nc), \; Nr)$

Still alternatively, when using the block interleaver 520B, a corresponding bloc de-interleaver can be implemented by using the following addressing scheme:

$$Shift = Nc/2+1 \; for \; mod(Nc,2)==0$$

$$Shift = (Nc+1)/2 \; for \; mod(Nc,2)==1$$

$$For \; j=0..N\_frames-1 \; \{$$

$$S = mod(S-Shift, \; Nc) \; with \; S=0 \; if \; j==0$$

$$For \; i=0..Nr*Nc-1 \; \{$$

$$R = mod(i, \; Nr)$$

$$T = mod(S*r, \; Nc)$$

$$C = mod(T+floor(i/Nr), \; Nc)$$

$$a_{(i,j)}=Nr*C+R$$

$$\}$$

$$\}$$

In the following, a simplified hybrid block and convolutional de-/interleaving and the corresponding method will be further described, in accordance with a further embodiment of the invention.

The block interleaver BI0 510 is a conventional row-column block interleaver whenever the number of cells per codeword, $N_{cells}$, is an integer multiple of the number of interleaving units, $N_{IU}$. However, if this is not the case, then a block interleaver needs to be employed, which skips trailing cells.

According to the DVB-NGH specification, we have $L_{(IU,min)} = floor(N_{cells}/N_{IU})$, where $floor(x)$ is the smallest integer not larger than x, and $N_{large} = mod(N_{cells}, \; N_{IU})$, and $N_{small} = N_{IU} - N_{large}$. Furthermore, the first $N_{large}$, interleaving units contain $L_{(IU,min)} +1$ cells, and the next $N_{small}$ interleaving units contain $L_{(IU,min)}$ cells, such that $N_{cells} = (L_{(IU,min)} +1) N_{large} + L_{(IU,min)} N_{small}$.

An example of such a block interleaver is schematically illustrated in Figure 8. It should be appreciated that such a block interleaver cannot directly be implemented with the memory saving DVB-T2 addressing scheme described above. Instead provisions are necessary to skip certain cells which results in extensive and complex logic.

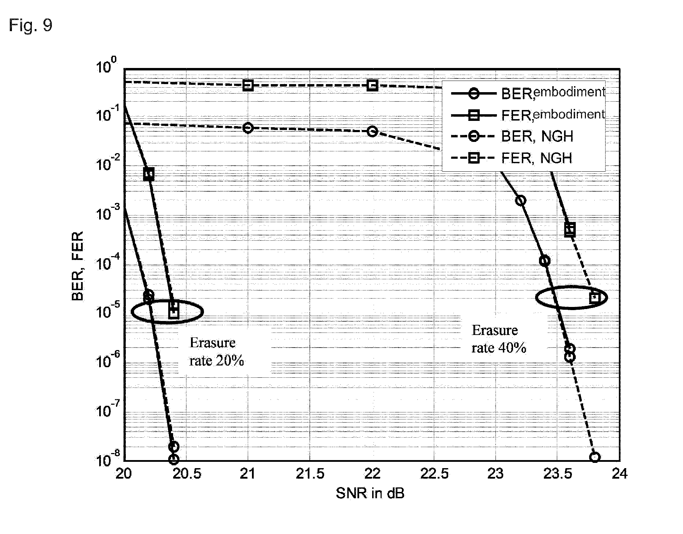

However, the inventor has realized that the block interleaver BI0 510 and block de-interleaver BDI0 710 form the outer components of the overall time de-/interleaver chain. So they can be simply removed from the chain without influencing the overall functionality and without degrading performances. Simulation results to support this finding are shown in Figure 9.

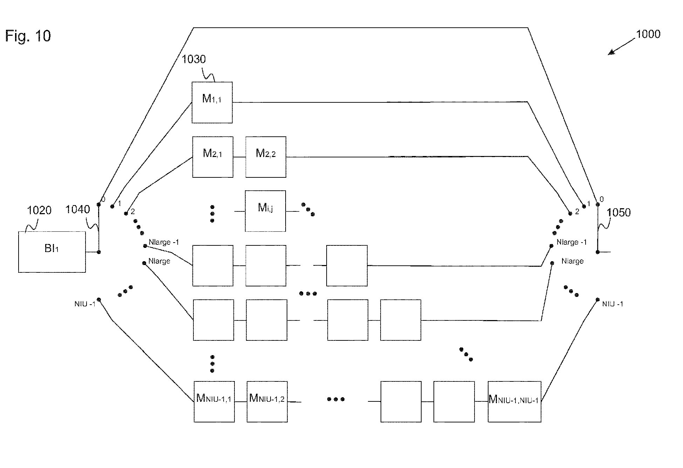

The corresponding time interleaver 1000 is depicted in Figure 10. The distribution of the codeword is determined by the switch 1040. In one embodiment the switch moves incrementally by one position after passing $N_{FEC\_TI}$ cells. The movement of switch 1050 replicates the movements of switch 1040. It should be noted that the present invention is not limited to moving switch 1040 and 1050 by one position after passing $N_{FEC\_TI}$ cells, and other increments are possible. In the latter case, the sizes of the FIFO-registers $M_{i,j}$ 1030 are adjusted. For instance, assuming that the switch jumps over every other position (i.e., firstly all even positions 0,2,4,..., then all odd positions 1,3,5,...), then the FIFO registers connected to the first even positions need to provide memory for $(L_{(IU,min)}+1)N_{FEC\_TI}$ cells, until $N_{large}$ interleaving units are exhausted. The remaining $N_{small}$ delay chains provides memory for $L_{(IU,min)} * N_{FEC\_TI}$ cells. The benefit is that a codeword is spread over a larger time span.

For block interleaver $BI_1$ 1020 any of the above block interleavers can be employed, in particular all possible implementations described for interleaver $BI_1$ 520, 520A, 520B.

At the transmitter the sizes of the FIFO-registers $M_{i,j}$ are $(L_{(IU,min)}+1) \cdot N_{FEC\_TI}$ for i = 1 ... $N_{large}$-1 and j = 1 ... i, for the first $N_{large}$ interleaving units, and $L_{(IU,min)} \cdot N_{FEC\_TI}$ for i = $N_{large}$ ... $N_{IU}$-1 and j = 1 ... i-1, for the second $N_{small}$ interleaving units.

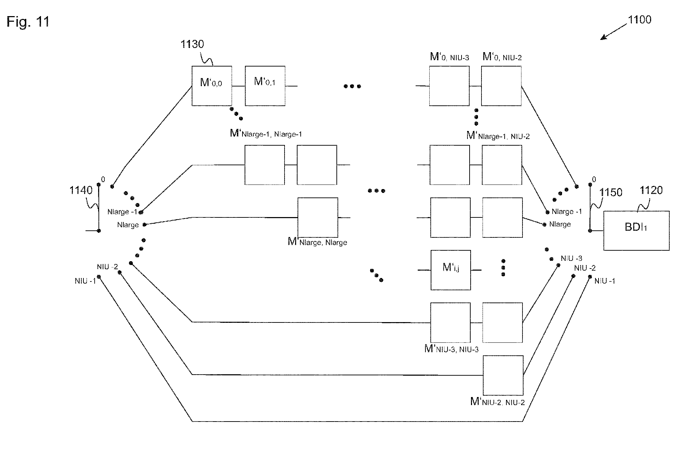

The corresponding time de-interleaver 1100 mirrors the functionality of the time interleaver 1000 and is schematically illustrated in Figure 11. Here, the switches 1140 and 1150 operate in accordance with switches 1040 and 1050. The considerations made above for block de-interleaver 720 applies to block de-interleaver 1120 as well.

Depending on whether or not $N_{cells}$ is an integer multiple of $N_{IU}$, the FIFO registers $M'_{i,j}$ have different sizes than their counterpart at the transmitter $M_{i,j}$. In particular, when $N_{cells}$ is an integer multiple of $N_{IU}$, all FIFO registers have the same size, i.e. $N_{cells} / N_{IU} * N_{FEC\_TI}$. In general terms, when $N_{cells}$ is not an integer multiple of $N_{IU}$, $M'_{i,j}$ equals

$(L_{(IU,min)}+1) \cdot N_{FEC\_TI}$ for i = 0 ... $N_{large}$-1 and j = i ... $N_{IU}$-2. $M'_{i,j}$ equals $L_{(IU,min)} \cdot N_{FEC\_TI}$ for i = $N_{large}$ ... $N_{IU}$-1 and j = i ... $N_{IU}$-2. The block de-interleaver $BDI_1$ reverts the functionality of the block-interleaver $BI_1$ and can be realized by any of the above block de-interleavers on the basis of a single block of RAM and the respecting addressing scheme, such as discussed for block de-interleaver 720.

It should be appreciated that the overall communication scheme faces block de-/interleaver only, since the delay chain is encapsulated by the block interleaver and de-interleaver.

Removing the outer block de-/interleavers $BI_0$ and $BDI_0$ as proposed in this embodiment changes the transmit sequence shown in Figure 3C, but has the benefit of simplifying the implementation. Figure 9 schematically illustrates simulation results comparing the performance of the DVB-NGH time interleaver and the interleaver 1000 according to the present embodiment of the invention. In particular Figure 9 illustrates, by way of error curves over the signal-to-noise-power ratio SNR, that the performance does not suffer by removing the outer block de-/interleavers $BI_0$ and $BDI_0$, i.e., the error curves relating to the DVB-NGH time interleaver and the present embodiment are substantially coinciding.

The simulations comprise a Rayleigh burst erasure channel with a fixed erasure burst, which occurs during the center of the interleaved cells. It emulates the propagation over a wireless channel with significant shadowing. The erasure rates (20% and 40%) relate to the time interleaving depth of the time interleaver. Further simulation parameters are as follows:

- Modulation: 256 non-uniform QAM

- LDPC codeword length $N_{ldpc}$ = 64 800, coderate 9/15

- Number of interleaving units: $N_{IU}$ = 15

- Number of codewords per IU: $N_{FEC\_TI}$ = 8

- Number of interleaving frames 30

It will be clear to those skilled in the art that, although several embodiments have been illustrated independently, they can be combined in order to obtain alternative embodiments, within the scope of the appended claims.

**Claims**

1. A hybrid de-interleaving method for de-interleaving input data, the method comprising the steps of:

   convolutionally de-interleaving (730-750, 1130-1150) the input data resulting into first intermediate data;
   first block de-interleaving (720, 1120) the first intermediate data, resulting into an output data.

2. The hybrid de-interleaving method according to claim 1, further comprising the step of:

   second block de-interleaving (710) the output data.

3. The de-interleaving method according to claim 1 or 2, wherein the first (720) and/or second (710) block de-interleaving steps are carried out in accordance with DVB-T2, DVB-C2, or row-twisting block de-interleaving.

4. The de-interleaving method according to any of claims 1 to 3, wherein the first and/or second block de-interleaving performs de-interleaving in accordance with the addressing scheme

$$(Eq1) \qquad a_{(i,j)} = (a_{(i-1,j)}+k_{(j)}) \ mod \ M + (a_{(i-1,j)}+k_{(j)}) \ div \ M$$

with

- $k_{(0)}$ = 1
- $a_{(0,j)}$ = 0
- $M = Nr \cdot Nc$

where *Nr* is the number of rows and *Nc* is the number of columns of the block de-interleaver and wherein $k_{(j)}$ is computed as

- $k_{(j)} = (k_{(j-1)} \cdot Nc) \bmod M + k_{(j-1)} \, div \, Nr$

5. The de-interleaving method according to any of claims 1 to 3, wherein the first and/or second block de-interleaving performs de-interleaving in accordance with the addressing scheme

$$(Eq2) \qquad a_{(i,j)} = Nc * r_{(i,j)} + c_{(i,j)}$$

with

- $i = 0 \ldots Nr*Nc-1$,
- $c_{(i,j)} = mod(i,Nc)$
- $s_{(i,j)} = mod(j*c_{(i,j)}, Nr)$
- $r_{(i,j)} = mod(s_{(i,j)}+floor(i/Nc), Nr)$

where *Nr* is the number of rows and *Nc* is the number of columns of the block de-interleaver.

6. The de-interleaving method according to any of claims 1 to 3, wherein the first and/or second block de-interleaving performs de-interleaving in accordance with the addressing scheme

$$Shift = Nc/2+1 \text{ for } mod(Nc,2)==0$$
$$Shift = (Nc+1)/2 \text{ for } mod(Nc,2)==1$$
$$For\ j=0..N\_frames-1\ \{$$
$$\qquad S = mod(S-Shift, Nc) \text{ with } S=0 \text{ if } j==0$$
$$\qquad For\ i=0..Nr*Nc-1\ \{$$
$$\qquad\qquad R = mod(i, Nr)$$
$$\qquad\qquad T = mod(S*r, Nc)$$
$$\qquad\qquad C = mod(T+floor(i/Nr), Nc)$$
$$\qquad\qquad a_{(i,j)}=Nr*C+R$$
$$\qquad \}$$
$$\}$$

where *Nr* is the number of rows and *Nc* is the number of columns of the block de-interleaver.

7. The de-interleaving method according to any of claims 1 to 6, wherein the step of convolutionally de-interleaving is logically equivalent to the operation of a convolutional de-interleaver comprising:

a first switch (740, 1140) connecting the input of the convolutional de-interleaver to a plurality of branches, the number of branches being equal to the number of interleaving units in which the data to be de-interleaved is arranged;
FIFO memories (730, 1130) connected to at least some of the branches;
a second switch (750, 1150) connecting the branches to an output of the convolutional de-interleaver;
wherein the first and/or second switch is configured to move to the next branch after a number of cells has passed though the switch, the number of cells being equal to the number of codewords per frame, and

wherein the first and/or second switch is configured to move from one of the plurality of branches to the next one until the last branch of the plurality of branches is reached, and then to move from the last branch to the first one.

8. A hybrid de-interleaver (700), the de-interleaver being adapted for performing the steps of a method according to any of claims 1 to 7.

9. A hybrid interleaving method for interleaving input data, the method comprising the steps of:

   first block interleaving (520, 1020) the input data, resulting into first intermediate data;
   convolutionally interleaving (530-550, 1030-1050) the first intermediate data resulting into output data.

10. The interleaving method according to claim 9, further comprising the step of
    second block interleaving (510) the input data before the first block interleaving step.

11. The interleaving method according to claim 9 or 10, wherein the first (520) and/or second (510) block interleaving steps are carried out in accordance with DVB-T2, DVB-C2, or row-twisting block interleaving.

12. The interleaving method according to any of claims 9 to 11, wherein the first and/or the second block interleaving performs interleaving in accordance with the addressing scheme

$$\text{(Eq1)} \qquad a_{(i,j)} = (a_{(i-1,j)} + k_{(j)}) \bmod M + (a_{(i-1,j)} + k_{(j)}) \ div \ M$$

with

- $k_{(0)} = 1$
- $a_{(0,j)} = 0$
- $M = Nr \cdot Nc$

where $Nr$ is the number of rows and $Nc$ is the number of columns of the block interleaver and wherein $k_{(j)}$ is computed as

- $k_{(j)} = (k_{(j-1)} \cdot Nr) \bmod M + k_{(j-1)} \ div \ Nc$

13. The interleaving method according to any of claims 9 to 11, wherein the first and/or the second block interleaving performs interleaving in accordance with the addressing scheme

$$\text{(Eq2)} \qquad a_{(i,j)} = Nc * r_{(i,j)} + c_{(i,j)}$$

with

- $i = 0 \ ... \ Nr*Nc-1$,
- $c_{(i,j)} = \bmod(i, Nc)$
- $s_{(i,j)} = \bmod(j*c_{(i,j)}, Nr)$
- $r_{(i,j)} = \bmod(floor(i/Nc) - s_{(i,j)}, Nr)$

where $Nr$ is the number of rows and $Nc$ is the number of columns of the block interleaver.

14. The interleaving method according to any of claims 9 to 11, wherein the first and/or the second block interleaving performs interleaving in accordance with the addressing scheme

$$Shift = Nc/2+1 \text{ for } mod(Nc,2)==0$$

$$Shift = (Nc+1)/2 \text{ for } mod(Nc,2)==1$$

$$For\ j=0..N\_frames-1\ \{$$

$$S = mod(S-Shift,\ Nc)\ with\ S=0\ if\ j==0$$

$$For\ i=0..Nr*Nc-1\ \{$$

$$R = mod(i,\ Nr)$$

$$T = mod(S*r,\ Nc)$$

$$C = mod(floor(i/Nr)-T,\ Nc)$$

$$a_{(i,j)}=Nr*C+R$$

$$\}$$

$$\}$$

where $Nr$ is the number of rows and $Nc$ is the number of columns of the block interleaver.

15. The interleaving method according to any of claims 9 to 14, wherein the step of convolutionally interleaving is logically equivalent to the operation of a convolutional interleaver comprising:

a first switch (540, 1040) connecting the input of the convolutional interleaver to a plurality of branches, the number of branches being equal to the number of interleaving units in which the data to be interleaved is arranged; FIFO memories (530, 1030) connected to at least some of the branches; a second switch (550, 1050) connecting the branches to an output of the convolutional interleaver; wherein the first and/or second switch is configured to move to the next branch after a number of cells has passed though the switch, the number of cells being equal to the number of codewords per frame, and wherein the first and/or second switch is configured to move from one of the plurality of branches to the next one until the last branch of the plurality of branches is reached, and then to move from the last branch to the first one

16. A hybrid interleaver (500), the interleaver being adapted for performing the steps of a method according to any of claims 9 to 15.

Fig. 1

Fig. 2

Fig. 3A

## Fig. 3B

## Fig. 3C

Fig. 4A

| 40 | 50 | 24 | 34 | 08 | 18 | 41 | 51 | 25 | 35 | 09 | 19 |
|----|----|----|----|----|----|----|----|----|----|----|----|

IN (n)

| 42 | 52 | 26 | 36 | 0A | 00 | 43 | 53 | 27 | 37 | 0B | 00 |
|----|----|----|----|----|----|----|----|----|----|----|----|

| 40 | 50 |
|----|----|
| 41 | 51 |
| 42 | 52 |
| 43 | 53 |

| 24 | 34 |
|----|----|
| 25 | 35 |
| 26 | 36 |
| 27 | 37 |

| 08 | 18 |
|----|----|
| 09 | 19 |
| 0A | 00 |
| 0B | 00 |

410

Fig. 4B

420

INT (n)

| 40 | 50 |
|----|----|
| 41 | 51 |
| 42 | 52 |
| 43 | 53 |

| 24 | 34 |
|----|----|
| 25 | 35 |
| 26 | 36 |
| 27 | 37 |

| 08 | 18 |
|----|----|
| 09 | 19 |
| 0A | 1A |
| 0B | 1B |

| 40 | 50 |
|----|----|
| 41 | 51 |
| 42 | 52 |
| 43 | 53 |

| 24 | 34 |
|----|----|
| 25 | 35 |
| 26 | 36 |
| 27 | 37 |

| 08 | 18 |
|----|----|
| 09 | 19 |
| 0A | 1A |
| 0B | 1B |

Fig. 4C

| | INT (n-2) | INT (n-1) | INT (n) | INT (n+1) | INT (n+2) | 430 | OUT (p) | OUT (p+1) | OUT(p+2) |
|---|---|---|---|---|---|---|---|---|---|

**IU0**

| 00 | 10 | 20 | 30 | 40 | 50 | | | | 00 | 10 | 20 | 30 | 40 | 50 |
| 01 | 11 | 21 | 31 | 41 | 51 | | | | 01 | 11 | 21 | 31 | 41 | 51 |
| 02 | 12 | 22 | 32 | 42 | 52 | | | | 02 | 12 | 22 | 32 | 42 | 52 |
| 03 | 13 | 23 | 33 | 43 | 53 | | | | 03 | 13 | 23 | 33 | 43 | 53 |

**IU1**

| 04 | 14 | 24 | 34 | 44 | 54 | | D | | 04 | 14 | 24 | 34 | 44 | 54 |
| 05 | 15 | 25 | 35 | 45 | 55 | | | | 05 | 15 | 25 | 35 | 45 | 55 |
| 06 | 16 | 26 | 36 | 46 | 56 | | | | 06 | 16 | 26 | 36 | 46 | 56 |
| 07 | 17 | 27 | 37 | 47 | 57 | | | | 07 | 17 | 27 | 37 | 47 | 57 |

**IU2**

| 08 | 18 | 28 | 38 | 48 | 58 | | D | D | 08 | 18 | 28 | 38 | 48 | 58 |
| 09 | 19 | 29 | 39 | 49 | 59 | | | | 09 | 19 | 29 | 39 | 49 | 59 |
| 0A | 1A | 2A | 3A | 4A | 4B | | | | 0A | 1A | 2A | 3A | 4A | 4B |
| 0B | 1B | 2B | 3B | 5A | 5B | | | | 0B | 1B | 2B | 3B | 5A | 5B |

Fig. 5

Fig. 6A

Fig. 6B

| 1B | 17 | 13 | 1A | 16 | 12 | 19 | 15 | 11 | 18 | 14 | 10 |
|----|----|----|----|----|----|----|----|----|----|----|----|

| 0B | 07 | 03 | 0A | 06 | 02 | 09 | 05 | 01 | 08 | 04 | 00 |
|----|----|----|----|----|----|----|----|----|----|----|----|

520

| 00 | 10 |
|----|----|
| 04 | 14 |
| 08 | 08 |
| 01 | 11 |
| 05 | 15 |
| 09 | 19 |
| 02 | 12 |
| 06 | 16 |
| 0A | 1A |
| 03 | 13 |
| 07 | 17 |
| 0B | 1B |

| 1B | 0B | 17 | 07 | 13 | 03 | 1A | 0A | 16 | 06 | 12 | 02 |
|----|----|----|----|----|----|----|----|----|----|----|----|

| 19 | 09 | 15 | 05 | 11 | 01 | 18 | 08 | 14 | 04 | 10 | 00 |
|----|----|----|----|----|----|----|----|----|----|----|----|

## Fig. 6C

| 1B | 17 | 13 | 1A | 16 | 12 | 19 | 15 | 11 | 18 | 14 | 10 |
|----|----|----|----|----|----|----|----|----|----|----|----|

| 0B | 07 | 03 | 0A | 06 | 02 | 09 | 05 | 01 | 08 | 04 | 00 |
|----|----|----|----|----|----|----|----|----|----|----|----|

520A

| 00 | 1B |
|----|----|
| 10 | 04 |
| 08 | 14 |
| 18 | 01 |
| 05 | 11 |
| 15 | 09 |
| 02 | 19 |
| 12 | 06 |
| 0A | 16 |
| 1A | 03 |
| 07 | 13 |
| 17 | 0B |

| 0B | 17 | 13 | 07 | 03 | 1A | 16 | 0A | 06 | 12 | 19 | 02 |
|----|----|----|----|----|----|----|----|----|----|----|----|

| 09 | 15 | 11 | 05 | 01 | 18 | 14 | 08 | 04 | 10 | 1B | 00 |
|----|----|----|----|----|----|----|----|----|----|----|----|

## Fig. 6D

| 1B | 17 | 13 | 1A | 16 | 12 | 19 | 15 | 11 | 18 | 14 | 10 |
|----|----|----|----|----|----|----|----|----|----|----|----|

| 0B | 07 | 03 | 0A | 06 | 02 | 09 | 05 | 01 | 08 | 04 | 00 |
|----|----|----|----|----|----|----|----|----|----|----|----|

520B

| 00 | 10 |
|----|----|
| 04 | 14 |
| 08 | 08 |
| 01 | 11 |
| 05 | 15 |
| 09 | 19 |
| 02 | 12 |
| 06 | 16 |
| 0A | 1A |
| 03 | 13 |
| 07 | 17 |
| 0B | 1B |

| 0B | 17 | 03 | 1A | 06 | 12 | 09 | 15 | 01 | 08 | 04 | 10 |
|----|----|----|----|----|----|----|----|----|----|----|----|

| 1B | 07 | 13 | 0A | 16 | 02 | 19 | 05 | 11 | 08 | 14 | 00 |
|----|----|----|----|----|----|----|----|----|----|----|----|

Fig. 6E

| 1B | 0B | 17 | 07 | 13 | 03 | 1A | 0A | 16 | 06 | 12 | 02 |

| 19 | 09 | 15 | 05 | 11 | 01 | 18 | 08 | 14 | 04 | 10 | 00 |

| 10 | 00 |

540

| 14 | 04 |

| 18 | 08 |

Fig. 6F

| 1B | 0B | 17 | 07 | 13 | 03 | 1A | 0A | 16 | 06 | 12 | 02 |

| 19 | 09 | 15 | 05 | 11 | 01 |

| 11 | 01 |

540

| 15 | 05 |

| 19 | 09 |

## Fig. 6G

| 5B | 4B | 57 | 47 | 53 | 43 | 5A | 4A | 56 | 46 | 52 | 42 |
|----|----|----|----|----|----|----|----|----|----|----|----|

| 3B | 2B | 37 | 27 | 33 | 23 | 3A | 2A | 36 | 26 | 32 | 22 |
|----|----|----|----|----|----|----|----|----|----|----|----|

| 39 | 29 | 35 | 25 | 31 | 21 | 38 | 28 | 34 | 24 | 30 | 20 |
|----|----|----|----|----|----|----|----|----|----|----|----|

| 1B | 0B | 17 | 07 | 13 | 03 | 1A | 0A | 16 | 06 | 12 | 02 |
|----|----|----|----|----|----|----|----|----|----|----|----|

| 19 | 09 | 15 | 05 | 11 | 01 | 18 | 08 | 14 | 04 | 10 | 00 |
|----|----|----|----|----|----|----|----|----|----|----|----|

530

540    $M_{1,0}$    550

$M_{2,0}$    $M_{2,1}$

| 19 | 09 | 35 | 25 | 53 | 43 | 18 | 08 | 34 | 24 | 52 | 42 |
|----|----|----|----|----|----|----|----|----|----|----|----|

| -  | -  | 17 | 07 | 33 | 23 | -  | -  | 16 | 06 | 32 | 22 |
|----|----|----|----|----|----|----|----|----|----|----|----|

| -  | -  | 15 | 05 | 31 | 21 | -  | -  | 14 | 04 | 30 | 20 |
|----|----|----|----|----|----|----|----|----|----|----|----|

| -  | -  | -  | -  | 13 | 03 | -  | -  | -  | -  | 12 | 02 |
|----|----|----|----|----|----|----|----|----|----|----|----|

| -  | -  | -  | -  | 11 | 01 | -  | -  | -  | -  | 10 | 00 |
|----|----|----|----|----|----|----|----|----|----|----|----|

## Fig. 7

## Fig. 8

Fig. 9

Fig. 10

Fig. 11

| | Europäisches Patentamt |
|---|---|
| | European Patent Office |
| | Office européen des brevets |

**Application Number**

EP 14 18 6891

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GOMEZ-BARQUERO DAVID ET AL: "DVB-NGH: The Next Generation of Digital Broadcast Services to Handheld Devices", IEEE TRANSACTIONS ON BROADCASTING, IEEE SERVICE CENTER, PISCATAWAY, NJ, US, vol. 60, no. 2, June 2014 (2014-06), pages 246-257, XP011549840, ISSN: 0018-9316, DOI: 10.1109/TBC.2014.2313073 [retrieved on 2014-06-04] * page 247, right-hand column; figure 1 * * section II.A "Bit Interleaved Coding and Modulation (BICM)"; figure 2 * ----- | 9,11,15, 16 | INV. H03M13/27 |
| X | David Barquero ET AL: "Time Interleaving in DVB-NGH" In: "Next Generation Mobile Broadcasting", 26 March 2013 (2013-03-26), CRC Press, XP055186745, ISBN: 978-1-43-989869-7 pages 355-388, DOI: 10.1201/b14186-15, * the whole document * ----- -/-- | 1-16 | |

TECHNICAL FIELDS SEARCHED (IPC)

H03M

The present search report has been drawn up for all claims

| Place of search | Date of completion of the search | Examiner |
|---|---|---|
| Munich | 5 May 2015 | Farman, Thomas |

**Europäisches Patentamt**
**European Patent Office**
**Office européen des brevets**

# EUROPEAN SEARCH REPORT

Application Number

EP 14 18 6891

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Catherine Douillard ET AL: "The Bit Interleaved Coded Modulation Module for DVB-NGH", 19th International Conference on Telecommunications (ICT), 2012, 25 April 2012 (2012-04-25), pages 1-6, XP055041408, Piscataway, NJ, US DOI: 10.1109/ICTEL.2012.6221327 ISBN: 978-1-46-730745-1 Retrieved from the Internet: URL:http://ieeexplore.ieee.org/stamp/stamp.jsp?tp=&arnumber=6221327 [retrieved on 2012-10-17] * section VI: "Time Interleaving"; figure 5 * | 1-16 | |
| A | US 3 652 998 A (FORNEY GEORGE DAVID JR) 28 March 1972 (1972-03-28) * column 4, line 12 - line 59 * | 2,10 | |
| X | DVB ORGANIZATION: "TM-NGH810r1_Optimised time interleaving for DVB-NGH r2.pdf", DVB, DIGITAL VIDEO BROADCASTING, C/O EBU - 17A ANCIENNE ROUTE - CH-1218 GRAND SACONNEX, GENEVA - SWITZERLAND, 10 April 2011 (2011-04-10), pages 1-17, XP017834522, * the whole document * | 1-16 | |
| A,D | WO 2010/061184 A1 (BRITISH BROADCASTING CORP [GB]; NOKES CHRISTOPHER RYAN [GB]; HAFFENDEN) 3 June 2010 (2010-06-03) * the whole document * | 4,12 | |

**TECHNICAL FIELDS SEARCHED (IPC)**

The present search report has been drawn up for all claims

| Place of search | Date of completion of the search | Examiner |
|---|---|---|
| Munich | 5 May 2015 | Farman, Thomas |

EPO FORM 1503 03.82 (P04C01)

# EP 3 001 572 A1

## ANNEX TO THE EUROPEAN SEARCH REPORT
## ON EUROPEAN PATENT APPLICATION NO.

EP 14 18 6891

05-05-2015

| Patent document cited in search report | | Publication date | Patent family member(s) | | Publication date |
|---|---|---|---|---|---|
| US 3652998 | A | 28-03-1972 | NONE | | |
| WO 2010061184 | A1 | 03-06-2010 | EP | 2377248 A1 | 19-10-2011 |
| | | | GB | 2465611 A | 26-05-2010 |
| | | | WO | 2010061184 A1 | 03-06-2010 |

For more details about this annex : see Official Journal of the European Patent Office, No. 12/82

**EP 3 001 572 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2010061184 A

### Non-patent literature cited in the description

- Digital Video Broadcasting (DVB); Frame structure channel coding and modulation for a second generation digital transmission system for cable systems (DVB-C2). *ETSI EN 302 769,* April 2011